# EUROPEAN PATENT APPLICATION

(11) **EP 1 990 839 A2**
(43) Date of publication of application: **12.11.2008**
(21) Application number: 08008724.0
(22) Date of filing: 09.05.2008
(51) Int. Cl.: H01L 31/0352

(54) **Solar cell module**

(30) Priority: 09.05.2007 JP 2007124729
(71) Applicant: SANYO Electric Techno Create Co., Ltd., Moriguchi City Osaka 570-8677 (JP)
(72) Inventor: Kinoshita, Toshihiro, Moriguchi City Osaka 570-8677 (JP); Maruyama, Eiji, Moriguchi City Osaka 570-8677 (JP); Hishida, Yuji, Moriguchi City Osaka 570-8677 (JP)
(74) Representative: Riesenberg, Axel

(57) **Abstract**

The first and second solar cells are arranged to be adjacent to each other in the arrangement direction. On the back surface of the first solar cell, the multiple first n-type regions are formed in the arrangement direction and the multiple first p-type regions are formed between each of the multiple first n-type regions. On the back surface of the second solar cell, the multiple second p-type regions are formed in the arrangement direction and the multiple second n-type regions are formed between each of the multiple second p-type regions. Each of the multiple first n-type regions and each of the multiple second p-type regions are formed on the back surface in a substantially straight line. Each of the multiple first p-type regions and each of the multiple second n-type regions are formed on the back surface in a substantially straight line.

## Description

### CROSS REFERENCE TO RELATED APPLICATIONS

This application is based upon and claims the benefit of priority from the prior Japanese Patent Application No. P 2007-124729, filed on May 9, 2007; the entire contents of which are incorporated herein by reference.

### BACKGROUND OF THE INVENTION

### Field of the Invention

The present invention relates to a solar cell module in which solar cells are electrically connected on the back surfaces thereof.

### Description of the Related Art

Solar cells directly convert clean and unlimitedly-supplied sunlight into electricity, and thus are expected as one of new energy sources.

Energy output per solar cell is approximately a several W. Accordingly, when solar cells are used as a power source for houses, buildings or the like, a solar cell module having multiple solar cells connected in series or parallel is used.

Here, there has been known a back-contact-type solar cell. This type of solar cell has a light-receiving surface receiving sunlight and the back surface provided on the opposite side of the light-receiving surface, and a p-side electrode and an n-side electrode are formed on the back surface thereof (See, for example, Japanese Patent Application Publication No. 2005-11869). With such solar cells, a large light-receiving area of the light-receiving surface can be secured.

In such solar cells, the p-side electrode is formed of multiple p-side finger electrodes formed in a first direction and a p-side bus bar electrode formed in a second direction substantially perpendicular to the first direction. The p-side bus bar electrode is in contact with one ends of the p-side finger electrodes. In addition, the n-side electrode is formed of multiple n-side finger electrodes having a similar configuration to that of the p-side finger electrodes, and an n-side bus bar electrode having a similar configuration to that of the p-side bus bar electrode. The p-side bus bar electrode is formed near one side along the second direction of the back surface, while the n-side bus bar electrode is formed near another side of the back surface opposed to the one side.

In a solar cell module, two solar cells arranged in the first direction are electrically connected by a conductive wiring member. The two solar cells are arranged so that the p-side bus bar electrode of a first one of the solar cells and the n-side bus bar electrode of the second solar cell next to the first solar cell can face to each other. The wiring member is connected to the p-side bus bar electrode of the first solar cell and the n-side bus bar electrode of the second solar cell next to the first solar cell. In other words, the wiring member is provided on both ends of the back surface of each of the solar cells.

When a solar cell module is manufactured by using solar cells connected by a wiring member as described above (hereinafter referred to as "a solar cell string"), pressure is applied to the solar cell string. Specifically, a laminated body is firstly formed by laminating a light-receiving surface side protection member, a first sealing material, the solar cell string, a second sealing material, and a back surface side protection member in this order. Subsequently, the laminated body is heated from upper and lower sides thereof to be thermocompressed.

On both ends of the back surface of each of the solar cells, wiring members are provided. Thereby, the solar cell string has a larger thickness in a portion provided with the wiring member than that in a portion not provided with any wiring member. Accordingly, when pressure is applied to the laminated body from the upper and lower sides thereof, the portion provided with the wiring member is likely to receive larger pressure than the portion not provided with any wiring. Consequently, there arises a problem that cracks are easily caused in solar cells.

### SUMMARY OF THE INVENTION

The present invention has been made in view of the foregoing problem. Accordingly, an object of the present invention is to provide a solar cell module with a configuration that can prevent solar cells from having cracks, and thereby leads to an improvement of a production yield thereof

An aspect of the present invention is to provide a solar cell module. In the solar cell module, multiple solar cells are arranged in an arrangement direction, and each solar cell has a light-receiving surface receiving sunlight and a back surface provided on the opposite side of the light-receiving surface. The multiple solar cells include: a first solar cell; and a second solar cell, which are arranged to be adjacent to each other. The first solar cell has: multiple first n-type regions, which are formed on the back surface in the arrangement direction; and first p-type region, which is formed on the back surface in the arrangement direction and is sandwiched between the multiple first n-type regions. The second solar cell has: multiple second p-type regions, which are formed on the back surface in the arrangement direction; and a second n-type region, which is formed on the back surface in the arrangement direction and is sandwiched between the multiple second p-type regions. In addition, each of multiple first n-type regions and each of multiple second p-type regions are formed in a substantially straight line on the back surface, while the first p-type region and the second n-type region are formed in a substantially straight line on the back surface.

According to the above-described aspect of the present invention, the first and second solar cells are arranged to be adjacent to each other in an arrangement direction. In addition, on the back surface of the first solar cell, the multiple first n-type regions arranged in the arrangement direction and the first p-type region sandwiched between the multiple first n-type regions are formed. Similarly, on the back surface of the second solar cell, the multiple second p-type regions formed in the arrangement direction and the second n-type region sandwiched between the multiple second p-type regions are formed. The first n-type and second p-type regions and the first p-type and second n-type regions are formed in a substantially straight line on each of the back surfaces.

Accordingly, when the first and second solar cells are electrically connected in series, the multiple first n-type regions and the multiple second p-type regions are connected by straight wiring members, so that the first p-type regions and the second n-type regions can be connected by the straight wiring members. In other words, on the back surfaces of the first and second solar cells, at least three wiring members are arranged in the arrangement direction.

As a result, even when pressure is applied to the first and second solar cells connected by the wiring members, from the upper and lower sides thereof in the modularization process of the solar cell module, the pressure can be dispersed to the entire back surface of each solar cell. In other words, concentration of pressure in one portion of the back surface of the solar cell can be avoided in the modularization process of the solar cell module. This prevents cracks from occurring although such crack might otherwise occur during the modularization process.

In addition, in the one aspect of the present invention, the first solar cell further includes: multiple first n-side bus bar electrodes, which is formed on each of the multiple first n-type regions in the arrangement direction; multiple first n-side finger electrodes, which are formed on the first n-type region so as to intersect with each of the first n-side bus bar electrode; a first p-side bus bar electrode, which is formed on the first p-type region in the arrangement direction; multiple first p-side finger electrodes, which are formed on the light-receiving surface; and multiple first through-hole electrodes, which pass through to the back surface from the light-receiving surface and electrically connects the first p-side bus bar electrode to the multiple first p-side finger electrodes. The second solar cell further includes: multiple second p-side bus bar electrodes, which are formed on each of the multiple second p-type regions in the arrangement direction; multiple second p-side finger electrodes, which are formed on the second p-type region so as to intersect with each of the second p-side bus bar electrodes; a second n-side bus bar electrode, which is formed on the second n-type region in the arrangement direction; multiple second n-side finger electrodes, which are formed on the light-receiving surface; and multiple second through-hole electrodes, which pass through to the back surface from the light-receiving surface and electrically connect between the second n-side bus bar electrode and each of the multiple second n-side finger electrodes. In addition, the first and second solar cells may be arranged so that the first p-side finger electrodes and the second n-side finger electrodes, which have opposite polarities, face in the same direction.

Moreover, in the one aspect of the present invention, each of the multiple first n-side bus bar electrodes and each of the multiple second p-side bus bar electrodes may be electrically connected by a conductive wiring member.

Furthermore, in the one aspect of the present invention, the first p-side bus bar electrode and the second n-side bus bar electrode may be electrically connected by a conductive wiring member.

### BRIEF DESCRIPTION OF THE DRAWINGS

Fig. 1 is a side view of a solar cell module 200 according to a first embodiment of the present invention;
Fig. 2A is a plane view of the light-receiving surface of a first solar cell. Fig. 2B is a view showing the back surface of the first solar cell. Fig. 2C is a cross-sectional view showing a section taken along the A-A line in Fig. 2A;
Fig. 3 is a partially-enlarged view of Fig. 2C;
Fig. 4A is a plane view showing a light-receiving surface of a second solar cell. Fig. 4B is a back view showing a back surface of the second solar cell. Fig. 4C is a cross-sectional view showing a section taken along the B-B line in Fig. 4A;
Fig. 5 is a partially-enlarged view of Fig. 4C;
Fig. 6 is a back view showing a state where the first and second solar cells 100a and 100b according to the first embodiment are connected;
Fig. 7 is a plane view showing the state where the first and second solar cells 100a and 100b according to the first embodiment are connected;
Fig. 8 is a back view showing a state where third and fourth solar cells 100c and 100d according to a second embodiment are connected;
Fig. 9 is a cross-sectional view showing a section taken along the C-C line in Fig. 8; and
Fig. 10 is a cross-sectional view showing a section taken along the D-D line in Fig. 8.

### DESCRIPTION OF THE PREFERRED EMBODIMENTS

Preferred embodiments of the present invention will be described below by referring to the drawings. Note that in the following description of the drawings, same or similar reference numerals are given to denote same or similar portions in the drawings. Note that the drawings are merely schematically shown and proportions of sizes and the like are different from actual ones. Thus, specific sizes and the like should be judged by referring to the description below. In addition, there are of course included portions where relationships or proportions of sizes of the drawings are different with respect to one another.

### First Embodiment

### (Schematic configuration of a solar cell module)

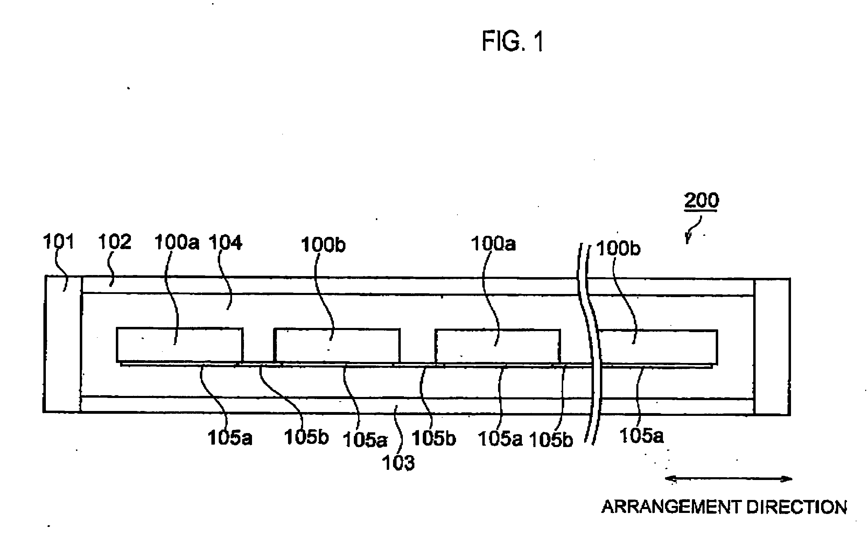

A schematic configuration of a solar cell module according to a first embodiment of the present invention will be descried below by referring to Fig. 1. Fig. 1 is a view showing the configuration of a solar cell module 200 according to the first embodiment of the present invention.

As shown in Fig. 1, the solar cell module 200 has multiple solar cells 100, a light-receiving surface side protection member 102, a back surface side protection member 103, and a sealing member 104. In addition, the solar cell module 200 has a wiring member 105 by which the solar cells adjacent to each other are connected in series. Furthermore, a frame body may be provided in an outer circumference of the solar cell module 200.

The solar cell 100 has a light-receiving surface receiving sunlight and a back surface provided on the opposite side of the light-receiving surface. The multiple solar cells 100 are arranged in an arrangement direction, and include first solar cells 100a, each of which has a p-type semiconductor region on the light-receiving surface, and second solar cells 100b, each of which has an n-type semiconductor region on the light-receiving surface. The first and second solar cells 100a and 100b are alternately arranged to be adjacent to each other.

The light-receiving surface side protection member 102 is formed of glass or the like and protects the solar cell module 200 from the light-receiving surface side. The back surface side protection member 103 is a film with resistance to weather and protects the solar cell module from the back surface side.

The sealing member 104 is formed of EVA (ethylene vinyl acetate) or the like and seals each solar cell 100 between the light-receiving surface side protection member 102 and the back surface side protection member 103.

The wiring member 105 is a conductive wiring member for electrically connecting the multiple solar cells 100. The wiring member 105 can be formed of a conductive material such as copper, which is molded in the form of a thin plate or a twisted wire.

In addition, the wiring member 105 includes a first wiring member 105a for carrying photogenerated carriers to be collected on the back surface of the solar cell and a second wiring member 105b for carrying photogenerated carriers to be collected on the light-receiving surface of the solar cell. The configuration of the first and second wiring members 105a and 105b will be described later.

The solar cell module 200 can be manufactured by the following modularization processes. Firstly, the light-receiving surface side protection member 102, the sealing member 104, the multiple solar cells 100, the sealing member 104, and the back surface side protection member 103 are laminated in this order to form a laminated body. Subsequently, while pressure is applied to the laminated body from the upper and lower sides thereof, the laminated body is heated.

### (Schematic configuration of the first solar cell 100a)

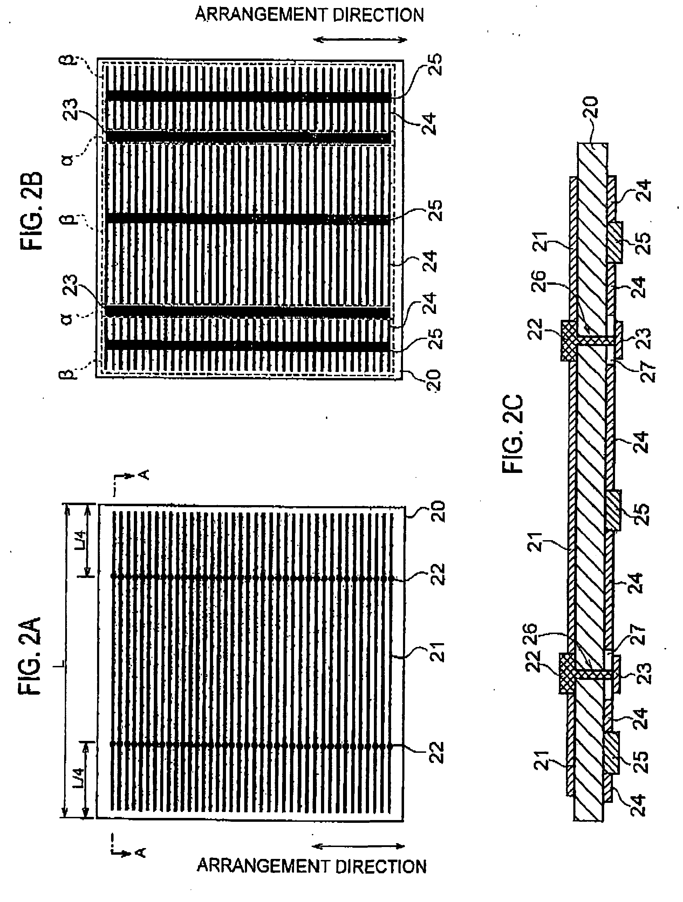

Next, the configuration of the first solar cell 100a will be described by referring to Fig. 2A to 2C. Fig. 2A is a plane view of the light-receiving surface of the first solar cell 100a. Fig. 2B is a view showing the back surface of the first solar cell 100a. Fig. 2C is a cross-sectional view showing a section taken along the A-A line in Fig. 2A.

The first solar cell 100a includes a first photoelectric converter 20 having an n-type semiconductor substrate, multiple fist p-side finger electrodes 21, multiple first through-hole electrodes 22, two first p-side bus bar electrodes 23, multiple first n-side finger electrodes 24, and three first n-side bus bar electrodes 25.

The first photoelectric converter 20 is formed by using an n-type semiconductor substrate and generates carriers when light is received from the light-receiving side. A carrier means a pair of a hole and an electron, which is produced when the first photoelectric converter 20 absorbs sunlight.

The first p-side finger electrodes 21 are collecting electrodes for collecting carriers (holes) generated in the first photoelectric converter 20. As shown in Fig. 2A, the first p-side finger electrodes 21 are formed in a line on the light-receiving surface in a direction substantially perpendicular to the arrangement direction in which the solar cells 100 are arranged. In addition, the multiple first p-side finger electrodes 21 are arranged in parallel at predetermined intervals, and can be formed by print processes by using, for example, a sintered conductive paste or thermoset conductive paste.

The multiple first through-hole electrodes 22 are collecting electrodes for further collecting the carriers that are collected by first p-side finger electrodes 21 from the first photoelectric converter 20. As shown in Fig. 2A, the first through-hole electrodes 22 are dotted like nodes. Specifically, the first through-hole electrodes 22 are formed in two lines in the form of a dotted line in the arrangement direction. One first through-hole electrode 22 is contacted with one first p-side finger electrode 21. Accordingly, the carries that are collected by the one first p-side finger electrode 21 are collected by two first through-hole electrodes 22. The first through-hole electrodes 22 can be formed of a conductive material similar to that used for the first p-side finger electrodes 21.

Here, each line of the first through-hole electrodes 22 is spaced, by 1/4 of a length L (that is, L/4), from one side of the first photoelectric converter 20.

In addition, the first through-hole electrodes 22 are filled in first through-holes 26 shown in Fig. 2C and reach to the back surface. The first through-holes 26 pass through the first photoelectric converter 20 (including the n-type semiconductor substrate) from the light-receiving surface to the back surface. Such first through-holes 26 can be formed by wet etching using a mixed solution of hydrofluoric acid and nitric acid, dry etching using Cl₂, Cl₄, or BCl₃, ion milling using Ar⁺, laser ablation using YAG laser, or the like.

The first p-side bus bar electrodes 23 are collecting electrodes for further collecting the carriers that are collected by the first through-hole electrodes 22 from the first p-side finger electrodes 21. The first p-side bus bar electrodes 23 are electrically connected to all the first p-side finger electrodes 21 formed on the light-receiving surface through the first through-hole electrodes 22.

In addition, as shown in Fig. 2B, the first p-side bus bar electrodes 23 are respectively formed inside two first p-type regions α, which are formed on the back surface in the arrangement direction. More specifically, the first p-side bus bar electrodes 23 are formed in two lines in the arrangement direction in which the solar cells 100 are arranged. The first p-side bus bar electrodes 23 can be formed of a conductive material similar to that used for the first p-side finger electrodes 21.

Furthermore, the first p-side bus bar electrodes 23 are formed in a symmetrical position with the first through-hole electrodes 22 on opposite sides of the first photoelectric converter 20. Here, each of the first p-side bus bar electrodes 23 is spaced, by 1/4 of a length L (that is, L/4), from one side of the first photoelectric converter 20.

The first n-side finger electrodes 24 are collecting electrodes for collecting carriers (electrons) generated in the first photoelectric converter 20. As shown in Fig. 2B, the first n-side finger electrodes 24 are formed inside first n-type regions β, which are formed on the back surface in the arrangement direction. Here, the first n-type regions β held the first p-type regions α therebetween. More specifically, the first n-type regions β are divided into three regions on the back surface. The first n-side finger electrodes 24 are formed inside the first n-type regions β in a line in the direction substantially perpendicular to the arrangement direction. In addition, the multiple first n-side finger electrodes 24 are arranged in parallel at predetermined intervals. Here, the first n-side finger electrodes 24 do not intersect with the first p-side bus bar electrodes 23. In other words, the first p-side bus bar electrodes 23 and the multiple first n-side finger electrodes 24 are electrically insulated. The first n-side finger electrodes 24 can be formed of a conductive material similar to that used for the first p-side finger electrodes 21.

As shown in Fig. 2B, the first n-side bus bar electrodes 25 are respectively formed inside the first n-type regions β, which are formed on the back surface in the arrangement direction. More specifically, the first n-side bus bar electrodes 25 are formed in three lines in the arrangement direction in which the solar cells 100 are arranged. Accordingly, the first n-side bus bar electrodes 25 intersect with and are electrically connected to the multiple first n-side finger electrodes 24. The first n-side bus bar electrodes 25 can be formed of a conductive material similar to that used for the first p-side finger electrodes 21.

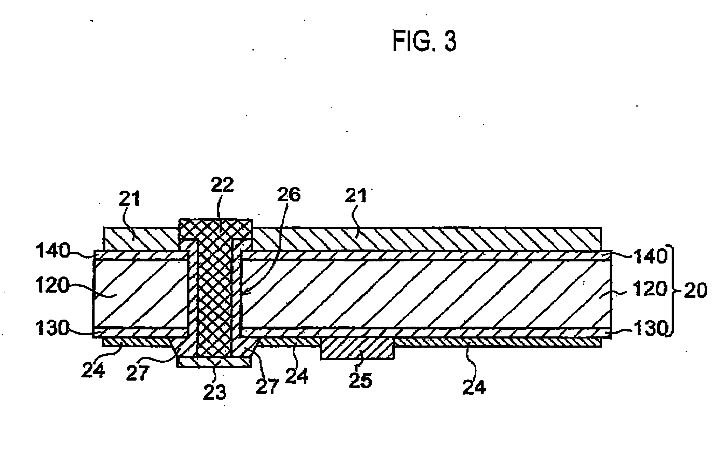

Fig. 3 is a partially-enlarged view of Fig. 2C. As shown in Fig. 3, the first photoelectric converter 20 includes an n-type crystalline system Si substrate 120, an n-type semiconductor layer 130, and a p-type semiconductor layer 140.

The n-type crystalline system Si substrate 120 generates carriers (electrons and holes) by absorbing sunlight. The n-type semiconductor layer 130 is, for example, an n-type amorphous Si layer formed on the back surface of the n-type crystalline system Si substrate 120. The n-type semiconductor layer 130 collects electrons generated in the n-type crystalline system Si substrate 120. The p-type semiconductor layer 140 is, for example, a p-type amorphous Si layer formed on the light-receiving surface of the n-type crystalline system Si substrate 120, and collects holes generated in the n-type crystalline system Si substrate 120. Note that the n-type semiconductor layer 130 and the p-type semiconductor layer 140 may be formed of crystalline system Si the same as the n-type crystal Si substrate 120. In addition, when the n-type semiconductor layer 130 and the p-type semiconductor layer 140 are formed of amorphous Si, an intrinsic amorphous silicon layer may be inserted between the n-type semiconductor layer 130 and the n-type crystalline system Si substrate 120 and between the p-type semiconductor layer 140 and the n-type crystalline system Si substrate 120.

As shown in Fig. 3, the first solar cell 100a further includes a first insulating member 27.

The first insulating member 27 is formed so as to cover the inner wall of the first through-hole 26 provided by passing through the p-type semiconductor layer 140, the n-type crystalline system Si substrate 120, and the n-type semiconductor layer 130. The first insulating member 27 causes the first through-hole electrode 22 to be insulated with the n-type crystalline system Si substrate 120, the n-type semiconductor layer 130, and the first n-side finger electrode 24.

### (Schematic configuration of the second solar cell 100b)

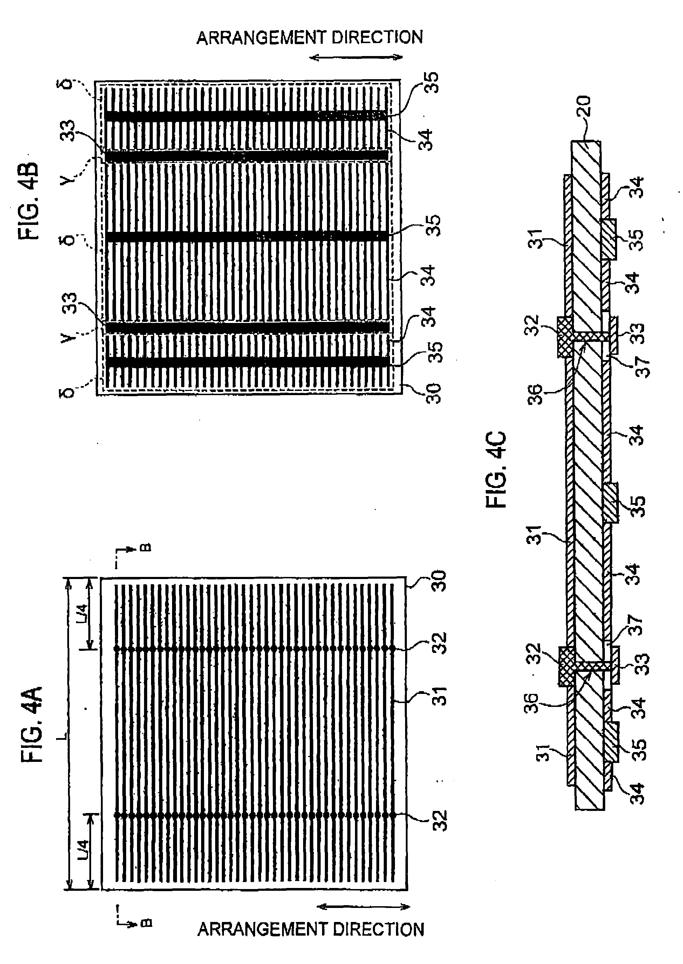

Next, the configuration of the second solar cell 100b will be described by referring to Figs, 4A and 4B. Fig. 4A is a plane view showing a light-receiving surface of the second solar cell 100b. Fig. 4B is a back view showing a back surface of the second solar cell 100b. Fig. 4C is a cross-sectional view showing a section taken along the B-B line in Fig. 4A.

The second solar cell 100b includes a second photoelectric converter 30 having an n-type semiconductor substrate, multiple second n-side finger electrodes 31, multiple second through-hole electrodes 32, two second n-side bus bar electrodes 33, multiple second p-side finger electrodes 34, and three second p-side bus bar electrodes 35.

The second photoelectric converter 30 is formed by using an n-type semiconductor substrate and generates carriers by receiving light from the light-receiving side.

The second n-side finger electrodes 31 are collecting electrodes for collecting carriers (electrons) generated in the second photoelectric converter 30. As shown in Fig. 4A, the second n-side finger electrodes 31 are formed in a line on the light-receiving surface in a direction substantially perpendicular to an arrangement direction in which the solar cells 100 are arranged. In addition, the multiple second n-side finger electrodes 31 are arranged in parallel at predetermined intervals, and can be formed by print processes by using, for example, a sintered conductive paste or thermoset conductive paste.

The multiple second through-hole electrodes 32 are collecting electrodes for further collecting the carriers that are collected by second n-side finger electrodes 31 from the second photoelectric converter 30. As shown in the plane view of the light receiving surface in Fig. 4A, the solar cell is dotted with the second through-hole electrodes 32 like nodes. Specifically, the second through-hole electrodes 32 are formed in two lines in the form of a dotted line in the arrangement direction. One second through-hole electrode 32 is formed to be in contact with one second n-side finger electrode 31. Accordingly, carriers that are collected by one second n-side finger electrode 31 are collected by two second through-hole electrodes 32. The second through-hole electrodes 32 can be formed of a conductive material similar to that used for the second n-side finger electrodes 31.

Here, each line of the second through-hole electrodes 32 is spaced, by 1/4 of a length L (that is, L/4), from one side of the second photoelectric converter 30.

In addition, the second through-hole electrodes 32 are filled in the second through-holes 36 shown in Fig. 4C and reach to the back surface. The second through-holes 36 pass through the second photoelectric converter 30 (including the n-type semiconductor substrate) from the light-receiving surface to the back surface.

The second n-side bus bar electrodes 33 are collecting electrodes for further collecting the carriers that are collected by the second through-hole electrodes 32 from the second n-side finger electrodes 31. Accordingly, the second n-side bus bar electrodes 33 are electrically connected to all the second n-side finger electrodes 31 formed on the light-receiving surface through the second through-hole electrodes 32.

As shown in Fig. 4B, the second n-side bus bar electrodes 33 are respectively formed inside second n-type regions γ, which are formed on the back surface in the arrangement direction. More specifically, the second n-side bus bar electrodes 33 are formed in two lines in the arrangement direction. The second n-side bus bar electrodes 33 can be formed of a conductive material similar to that used for the second n-side finger electrodes 31.

Furthermore, the second n-side bus bar electrodes 33 are formed in a position symmetrical to the second through-hole electrodes 32 on the opposite side of the second photoelectric converter 30. Here, each of the second n-side bus bar electrodes 33 is spaced, by 1/4 of a length L (that is, L/4), from one side of the second photoelectric converter 30.

The second p-side finger electrodes 34 are collecting electrodes for collecting carriers (holes) generated in the second photoelectric converter 30. As shown in Fig. 4B, the second p-side finger electrodes 34 are formed inside second p-type regions δ, which are formed on the back surface in the arrangement direction. Here, the second p-type regions δ sandwich each of the second n-type regions γ therebetween. More specifically, the second p-type regions δ are divided into three regions on the back surface. The second p-side finger electrodes 34 are formed in a line in the direction substantially perpendicular to the arrangement direction inside each of the second p-type regions δ. In addition, the multiple second p-side finger electrodes 34 are arranged in parallel at predetermined intervals. Here, the second p-side finger electrodes 34 do not intersect with the second n-side bus bar electrodes 33. In other words, the second p-side finger electrodes 34 and the second n-side bus bar electrodes 33 are electrically insulated. The second p-side finger electrodes 34 can be formed of a conductive material similar to that used for the second n-side finger electrodes 31.

As shown in Fig. 4B, the second p-side bus bar electrodes 35 are formed inside the second p-type regions δ, which are formed on the back surface in the arrangement direction. More specifically, the second p-side bus bar electrodes 35 are formed in three lines in the arrangement direction. Accordingly, the second p-side bus bar electrodes 35 intersect with and electrically connected to the multiple second p-side finger electrodes 34. The second p-side bus bar electrodes 35 can be formed of a conductive material similar to that used for the second n-side finger electrodes 31.

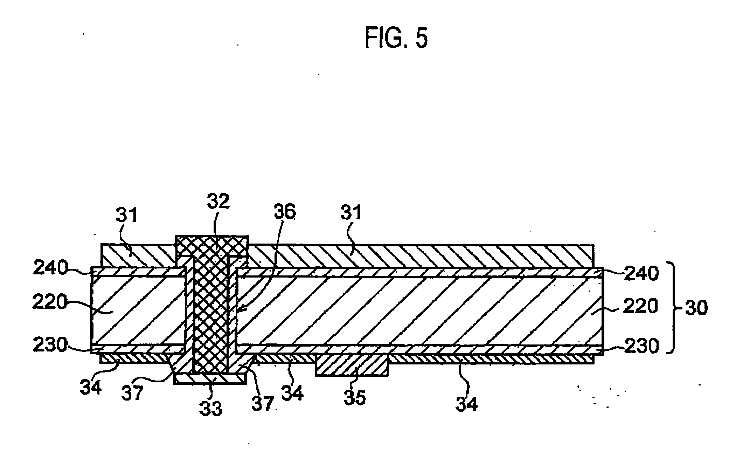

Fig. 5 is a partially-enlarged view of Fig. 4C. The second photoelectric converter 30 has the configuration in which the first photoelectric converter 20 provided to the first solar cell 100a is overturned. Specifically, as shown in Fig. 5, the second photoelectric converter 30 includes an n-type crystalline system Si substrate 220, a p-type semiconductor layer 230, and an n-type semiconductor layer 240.

The n-type crystalline system Si substrate 220 generates carriers (electrons and holes) by absorbing sunlight. The p-type semiconductor layer 230 is, for example, a p-type amorphous Si layer formed on the back surface of the n-type crystalline system Si substrate 220. The p-type semiconductor layer 230 collects holes generated in the n-type crystalline system Si substrate 220. The n-type semiconductor layer 240 is, for example, an n-type amorphous Si layer formed on the light-receiving surface of the n-type crystalline system Si substrate 220, and collects electrons generated in the n-type crystalline system Si substrate 220. Note that the p-type semiconductor layer 230 and the n-type semiconductor layer 240 may be formed of crystalline system Si the same as the n-type crystal Si substrate 220.

As shown in Fig. 5, the second solar cell 100b further includes a second insulating member 37.

The second insulating member 37 is formed so as to cover the inner wall of the second through-hole 36 provided by passing through the n-type semiconductor layer 240, the n-type crystalline system Si substrate 220, and the p-type semiconductor layer 230. The second insulating member 37 causes the second through-hole electrode 32 to be insulated with the n-type crystalline system Si substrate 220, the p-type semiconductor layer 230, and the second p-side finger electrode 34.

Here, as shown in Fig. 1, the first and second solar cells 100a and 100b are alternately arranged to be adjacent to each other in the arrangement direction. Accordingly, the first p-type regions α and the second n-type regions γ are formed in a substantially straight line on the back surface. Similarly, .the first n-type regions β and the second p-type regions δ are formed in a substantially straight line on the back surface.

### (Connection of the first and second solar cells 100a and 100b)

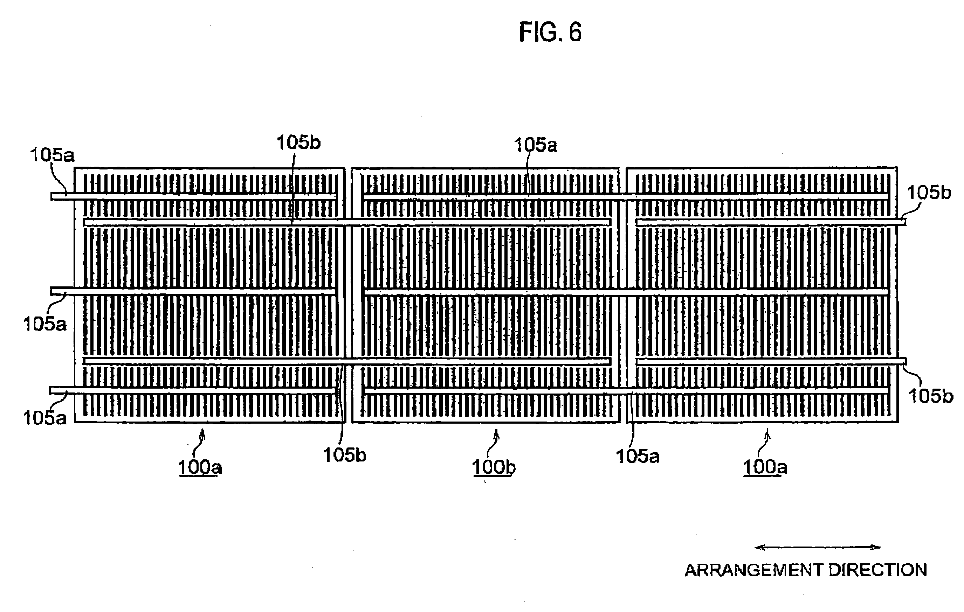

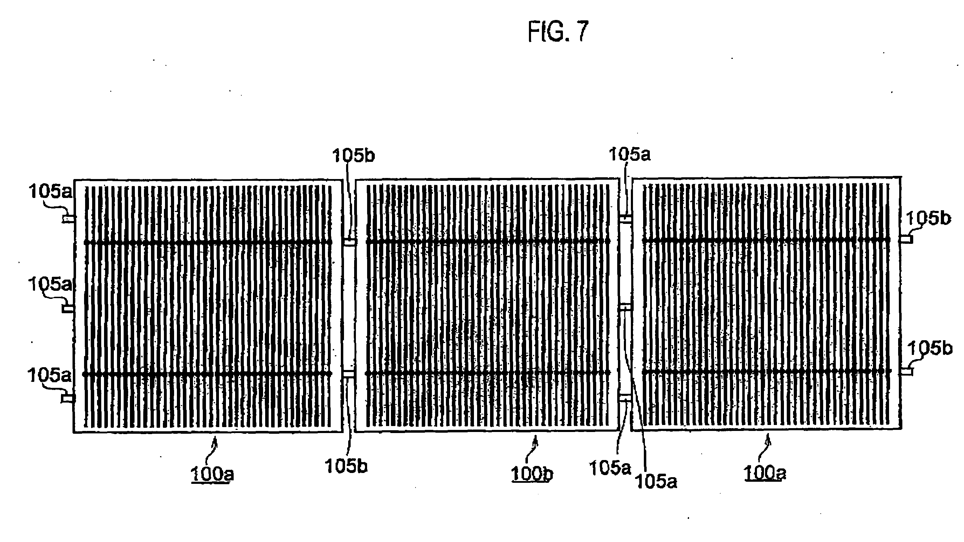

Next, by referring to Figs. 6 and 7, connection of the first and second solar cells 100a and 100b will be described. Fig. 6 is a back view showing a state where the first and second solar cells 100a and 100b are connected.

Fig. 7 is a plane view showing the state where the first and second solar cells 100a and 100b are connected.

As shown in Fig. 6, one first solar cell 100a (on the left in the figure) and one second solar cell 100b (in the center) are connected through two second wiring members 105b.

Specifically, the second wiring members 105b are connected to the first p-side bus bar electrodes 23, which are included in the one first solar cell 100a, and the second n-side bus bar electrodes 33, which are included in the one second solar cell 100b, by using a resin material containing conductive particles or a conductive adhesive such as soldering. Accordingly, the second wiring members 105b connect the first p-type regions α to the second n-type regions γ in the arrangement direction.

In addition, as shown in Fig. 6, the other solar cell 100a (on the right in the figure) and the one second solar cell 100b (in the center) are connected through three first wiring members 105a.

Specifically, the first wiring members 105a are connected to the first n-side bus bar electrodes 25, which are included in the other solar cell 100a, and the second p-side bus bar electrodes 35, which are included in the one second solar cell 100b, by using a resin material containing conductive particles or a conductive adhesive such as soldering. Accordingly, the first wiring members 105a connect the first n-type regions β to the second p-type regions δ in the arrangement direction.

As described above, the one first solar cell 100a (on the left in the figure), the one second solar cell 100b (in the center) and the other first solar cell 100a (on the right) are electrically connected in series by using the first and second wiring members 105a and 105b.

### (Effects)

With the solar cell module 200 according to the present embodiment, the first and second solar cells 100a and 100b, each of which has semiconductor regions with opposite polarities on the light-receiving surface, are arranged to be adjacent to each other in the arrangement direction in which the solar cells 100 are arranged. In addition, the multiple first n-type regions β formed in the arrangement direction and each of the first n-type regions α sandwiched between the multiple first n-type regions β are formed on the back surface of the first solar cell 100a. Similarly, the multiple second p-type regions δ formed in the arrangement direction and each of the second n-type regions γ sandwiched between the multiple second p-type regions δ are formed on the back surface of the second solar cell 100b. The first n-type and second p-type regions β and δ and the first p-type and second n-type regions α and γ are respectively formed in a substantially straight line on the back surfaces.

As described above, in the solar cell module 200 according to the present embodiment, the solar cells, each of which has the semiconductor regions with opposite polarities on the light-receiving surface, are arranged to be adjacent to each other. Thus, the n-type regions of the one solar cell and the p-type regions of the other solar cell can be formed in a substantially straight line on the back surfaces. In addition, the p-type regions of the one solar cell and the n-type regions of the other solar cell can be formed in a substantially straight line on the back surfaces. Accordingly, when the first and second solar cells 100a and 100b are electrically connected in series, the first n-type regions β and the second p-type regions δ can be connected by the straight wiring members 105,as well as the first p-type regions α and the second n-type regions γ can be respectively connected by the straight wiring members 105. In other words, on the back surfaces of the first and second solar cells 100a and 100b, at least three wiring members 105 are arranged in the arrangement direction.

Consequently, even when pressure is applied to the first and second solar cells 100a and 100b connected by the wiring members 105 from the upper and lower sides thereof in the modularization process of the solar cell module 200, the pressure can be dispersed to the entire back surface of each solar cell. In other words, in the modularization process of the solar cell module 200 concentration of force in one portion of the back surfaces of the solar cells 100 can be avoided.

As described above, the solar cell module 200 according to present invention can prevent cracks of the solar cells 100 during the modularization process.

In addition, in the solar cell module 200 according to the present embodiment, the multiple first n-type regions β for collecting carriers from the back surface are formed so as to sandwich each of the first p-type regions α for collecting carriers from the light-receiving surface. Similarly, the multiple second p-type regions δ for collecting carriers from the back surface are formed so as to sandwich each of the second n-type regions γ for collecting carriers from the light-receiving surface. Accordingly, the first n-side finger electrodes 24 and the second p-side finger electrodes 34 can be formed in the outside of the first p-side bus bar electrodes 23 and the second n-side bus bar electrodes 33. Consequently, the efficiency of power collection can be improved on the back surface.

Furthermore, the solar cell module 200 according to the present embodiment can collect carriers from substantially all regions on the back surfaces except portions where the first through-holes 26 and the second through-holes 36 are formed. Thereby; the power generation efficiency of the solar cell module 200 can be improved.

Moreover, the wiring members 105 can be collectively provided on the back surfaces of the first and second solar cells 100a and 100b. Accordingly, the process of connecting the multiple solar cells 100 by the wiring members 105 can be simplified.

### Second Embodiment

The configuration of a solar cell module according to a second embodiment of the present invention will be described below.

The solar cell module according to the present embodiment has a similar schematic configuration to that of the solar cell module 200 shown in Fig. 1.

The solar cell module according to the present embodiment includes multiple solar cells 100 which are arranged in an arrangement direction.

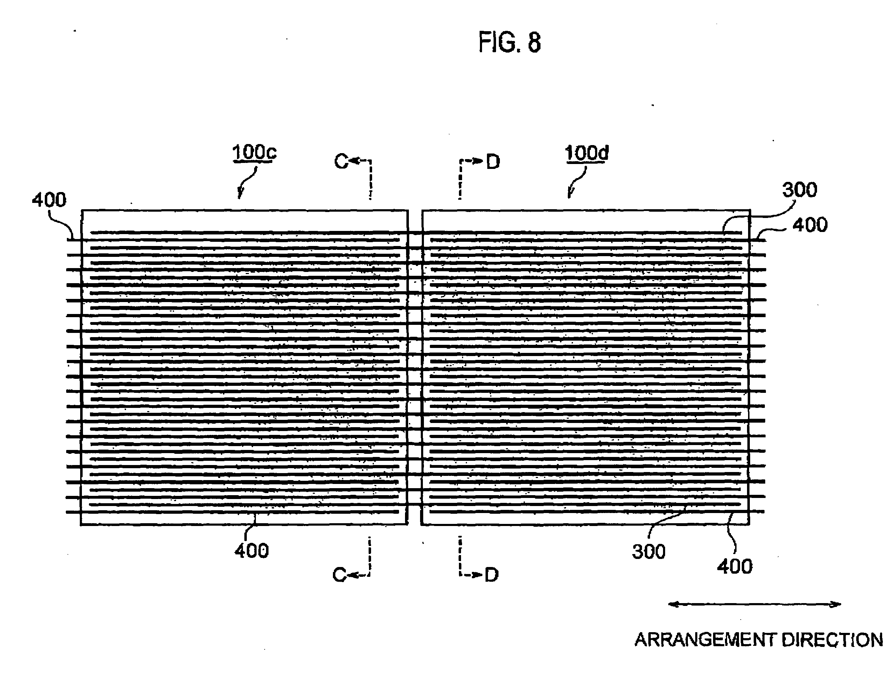

Fig. 8 is a back view showing a state where third and fourth solar cells 100c and 100d are connected on a back surface. In the solar cell module according to the present embodiment, the third and fourth solar cells 100c and 100d are alternately arranged to be adjacent to each other in the arrangement direction.

Photoelectric converters of the third and fourth solar cells 100c and 100d may be manufactured by using semiconductor substrates having the same polarity, or semiconductor substrates having opposite polarities.

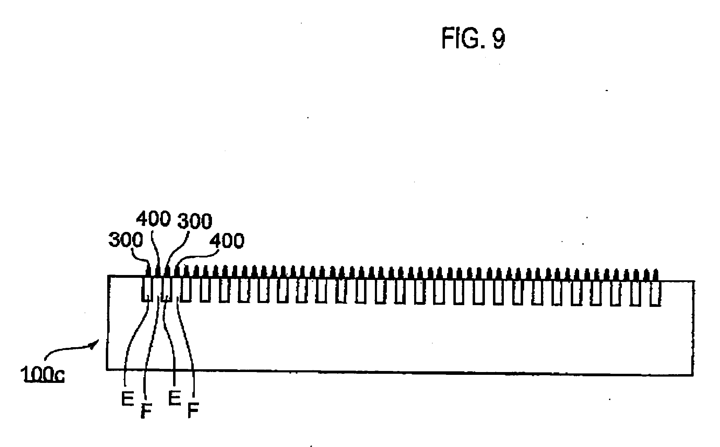

Fig. 9 is a cross-sectional view showing a section taken along the C-C line in Fig. 8. As shown in Fig. 9, a collection electrode for collecting carriers (electrons and holes) generated in the photoelectric converter is not formed on the light-receiving surface and back surface of the third solar cell 100c.

As shown in Figs. 8 and 9, on a substantially entire region of the back surface of the third solar cell 100c, third n-type regions E and third P-type regions F are alternately formed in a line in the arrangement direction. Electrons generated in the third n-type regions E are collected by wiring members 300, while holes generated in the third p-type regions F are collected by wiring members 400.

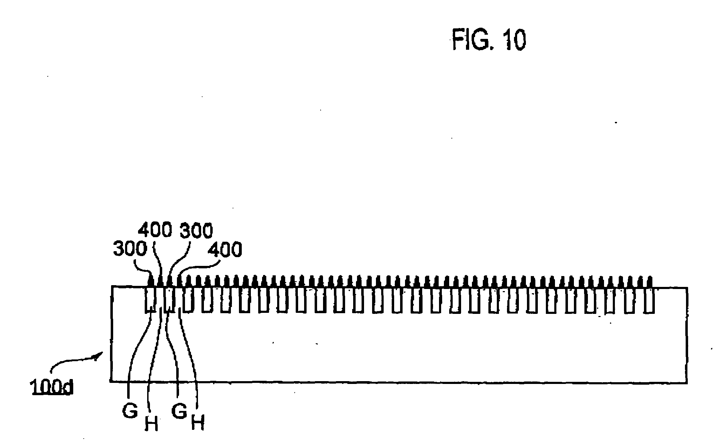

Fig. 10 is a cross-sectional view showing a section taken along the D-D line in Fig. 8. As shown in Fig. 10, a collection electrode for collecting carriers generated in the photoelectric converter on the light-receiving surface and back surface of the fourth solar cell 100d.

As shown in Figs. 8 and 9, on a substantially entire region of the back surface of the fourth solar cell 100d, fourth p-type regions G and fourth n-type regions H are alternately formed in a line in the arrangement direction. Holes generated in the fourth p-type regions G are collected by wiring members 300, while electrons generated in the fourth n-type regions H are collected by wiring members 400. The wiring members 300 and 400 are conductive wires formed in such a manner that a conductive material such as copper is processed by thinning process. The wiring members 300 are disposed to be in contact with the third n-type regions E and the fourth p-type regions G, while the wiring members 400 are disposed to be in contact with the third p-type regions F and the fourth n-type regions H.

Here, in the present embodiment, the third n-type regions E and the fourth p-type regions G are formed in a substantially straight line on the back surface. In addition, the third p-type regions F and the fourth n-type regions H are formed in a substantially straight line on the back surface. Accordingly, the wiring members 300 and 400 according to the present embodiment are formed in a substantially straight line.

As described above, the third and fourth solar cells 100c and 100d are electrically and mechanically connected by the wiring members 300 and 400, which are alternately provided in the arrangement direction.

### (Effects)

With the solar cell module according to the present embodiment, the multiple third n-type regions E formed in the arrangement direction and the third p-type region F sandwiched between the multiple third n-type regions E are formed on the back surface of the third solar cell 100c. Similarly, the multiple fourth p-type regions G formed in the arrangement direction and the fourth n-type region H sandwiched between the multiple fourth p-type regions G are formed on the back surface of the fourth solar cell 100d. The third n-type regions E and the fourth p-type regions G are formed in a substantially straight line on the back surface. The third p-type region F and the fourth n-type region H are formed in a substantially straight line on the back surface.

As described above, in the solar cell module in the present embodiment, multiple n-type regions of one solar cell and multiple p-type regions of the other solar cell are formed in a substantially straight line on the back surface, while multiple p-type regions of one solar cell and multiple n-type regions of the other solar cell are formed in a substantially straight line on the back surface. Accordingly, when the third and fourth solar cells 100c and 100d are electrically connected in series, the third n-type regions E and the fourth p-type regions G can be connected by multiple straight wiring members 300. In addition, the third p-type regions F and fourth n-type regions H can be connected by multiple straight wiring members 400.

Accordingly, even when pressure is applied to the third and fourth solar cells 100c and 100d, which are connected by the wiring members 300 and 400, from the upper and lower sides thereof in the modularization process of the solar cell module, the pressure can be dispersed to the entire back surfaces of each solar cell. In other words, pressure is prevented from concentrating in one portion of solar cell during the modularization process. Thereby, pressure applied during the modularization process can be dispersed, which prevents cracks from occurring in the solar cells.

In addition, a bus bar electrode is not formed in the third and fourth solar cells 100c and 100d, but the wiring members 300 and 400 can connect between the solar cells. Accordingly, carriers can be collected from almost entire region on the back surfaces. Thereby, power generation efficiency of the solar cell module can be further improved.

### (Other embodiment)

The present invention has been described by using the above-described embodiments. However, it should be understood that the description constituting one part of the present disclosure and drawings are not intended to limit the present invention. For those who are in the art, various alternative embodiments, examples, and operational techniques will be apparent from the present disclosure.

For example, in the above-described first embodiment, the first and second photoelectric converters 20 and 30 include the n-type semiconductor substrate. However, both can include a p-type semiconductor substrate or semiconductor substrates having opposite polarities. In the above-described first embodiment, it is only needed that each of the first and second solar cells 100a and 100b has a semiconductor region with a polarity, which is different from that of the other, as a light-receiving surface.

In addition, in the above-described first embodiment, the first solar cell 100a includes the first n-side bus bar electrodes 25. However, the wiring members 105 may be directly connected to the first n-side finger electrodes 24. Similarly, the second solar cell 100b includes the second p-side bus bar electrodes 35. However, the wiring members 105 may be directly connected to the second p-side finger electrodes 34. Thereby, efficiency of power collection can be improved.

Moreover, in the above-described first embodiment, the bus bar electrodes are formed in the arrangement direction, but are not necessarily formed to be completely parallel to the arrangement direction.

## Claims

1. A solar cell module comprising:
a plurality of solar cells arranged in an arrangement direction, the plurality of solar cells each having a light-receiving surface receiving sunlight and a back surface provided on the opposite side of the light-receiving surface,
wherein
the plurality of solar cells includes a first solar cell and a second solar cell which are arranged to be adjacent to each other,
the first solar cell comprises:
a plurality of first n-type regions formed on the back surface in the arrangement direction; and
a first p-type region formed between two adjacent first n-type regions included in the plurality of first n-type regions on the back surface in the arrangement direction, and
the second solar cell comprises:
a plurality of second p-type regions formed on the back surface in the arrangement direction; and
a second n-type region formed between two adjacent second p-type regions included in the plurality of second p-type regions on the back surface in the arrangement direction,
wherein
the plurality of first n-type regions and the plurality of second p-type regions are formed on the back surface in a substantially straight line, and the first p-type region and the second n-type region are formed on the back surface in a substantially straight line.

2. The solar cell module according to claim 1, wherein
the first solar cell further comprises:
a plurality of first n-side bus bar electrodes formed on each of the plurality of first n-type regions in the arrangement direction;
a plurality of first n-side finger electrodes formed on each of the plurality of first n-type regions so as to intersect with each of the plurality of first n-side bus bar electrodes;
a first p-side bus bar electrode formed on the first p-type region in the arrangement direction;
a plurality of first p-side finger electrodes formed on the light-receiving surface; and
a plurality of first through-hole electrodes passing through the first solar cell from the light-receiving surface to the back surface to electrically connect the first p-side bus bar electrode and the plurality of first p-side finger electrodes, and
the second solar cell further comprises:
a plurality of second p-side bus bar electrodes formed on each of the plurality of second p-type regions in the arrangement direction;
a plurality of second p-side finger electrodes formed on each of the second p-type regions so as to intersect with each of the plurality of second p-side bus bar electrodes;
a second n-side bus bar electrode formed on the second n-type region in the arrangement direction;
a plurality of second n-side finger electrodes formed on the light-receiving surface; and
a plurality of second through-hole electrodes passing through the second solar cell from the light-receiving surface to the back surface to electrically connect the second n-side bus bar electrode and the plurality of second n-side finger electrodes,
wherein
the first solar cell and the second solar cell are arranged so that the plurality of first p-side finger electrodes and the second n-side finger electrodes, which have opposite polarities, face in the same direction.

3. The solar cell module according to claim 2, wherein each of the plurality of first n-side bus bar electrodes and each of the plurality of second p-side bus bar electrodes are electrically connected by a conductive wiring material.

4. The solar cell module according to claim 2, wherein the first p-side bus bar electrode and the second n-side bus bar electrode are electrically connected by a conductive wiring material.
